# EUROPEAN PATENT SPECIFICATION

(11) **EP 3 021 155 B1**
(45) Date of publication and mention of the grant of the patent: **11.04.2018**
(21) Application number: 13889068.6
(22) Date of filing: 08.07.2013
(51) Int. Cl.: G02B 26/10, B81B 7/00, G02B 26/08

(54) **ACTUATOR**
STELLGLIED
ACTIONNEUR

(43) Date of publication of application: 18.05.2016
(73) Proprietor: Pioneer Corporation, Tokyo 113-0021 (JP); Pioneer Micro Technology Corporation, Yamanashi 400-0053 (JP)
(72) Inventor: FUJIMOTO, Kenjiro, Kawasaki-shi, Kanagawa 212-0031 (JP); YAMAMURA, Yuuichi, Kofu-shi, Yamanashi 400-0053 (JP)
(74) Representative: Viering, Jentschura & Partner mbB Patent- und Rechtsanwälte
(86) International application number: PCT/JP2013/068634
(87) International publication number: WO 2015/004710

(56) References cited:
- WO-A2-2013/081458
- JP-A- 2010 128 116
- JP-A- 2013 080 068
- US-A1- 2012 162 739

## Description

### Technical Field

The present invention relates to an actuator, such as, for example, a micro electro mechanical system (MEMS) scanner configured to drive a movable part provided with a mirror or the like.

### Background Art

In various technical fields, such as, for example, a display, a printing apparatus, precise measurement, precision processing, and information recording / reproduction, research on a MEMS device manufactured by a semiconductor process technology has been actively conducted. As such a MEMS device, the MEMS scanner used for laser light scanning is provided with a movable plate, a support frame in a frame shape that surrounds the movable plate, and a torsion bar that pivotably supports the movable plate oscillably with respect to the support frame.

In such a MEMS scanner, stress (e.g. stress that twists the torsion bar) is applied to the torsion bar in many cases, in order to oscillate the movable plate. However, when the twisting stress is applied to the torsion bar, stress is applied not only to the torsion bar but also to a part or all of the movable plate in many cases. The stress applied to the movable plate as described above causes deformation of the movable plate.

The deformation of the movable plate, however, also causes deformation of the mirror or the like formed on the movable plate. The deformation of the mirror or the like as described above causes a reduction in accuracy of the laser light scanning, and it is thus hardly preferable. Therefore, in order to suppress the deformation of the movable plate (i.e. to maintain flatness or planarity of the movable part), there is proposed a technology of forming a convex rib on a surface of the movable part (or typically, on a surface opposite to the surface with the mirror formed thereon) (e.g. refer to Patent Literatures 1 to 3).

### Citation List

### Patent Literature

Patent Literature 1: Japanese Patent Application Laid Open No. 2003-172897
Patent Literature 2: Japanese Patent Application Laid Open No. 2007-310342
Patent Literature 3: Japanese Patent Application Laid Open No. 2005-308820

US 2012/162739 A1 discloses that an optical scanning device includes a mirror, a mirror supporting part to support the mirror on an upper surface, and a pair of torsion beams to support the mirror supporting part from both sides in an axis direction and to drive the mirror supporting part so as to swing the mirror supporting part around the axis by being twisted (cf. Abstract). This document also discloses that a rib is provided on the back side of the mirror supporting part (cf. paragraph [0092]).

WO 2013/081458 A2 discloses that a MEMS-micro-mirror comprises a mirror body that is rotatably arranged in a mirror frame around a rotation axis extending in a plane defined by the mirror body, wherein the rotation axis extends through a first and a second mutually opposite end-portion of the mirror body (cf. Abstract).

### Summary of Invention

### Technical Problem

The formation of the rib on the movable plate can suppress the deformation of the movable plate; however, high stress is possibly applied to a connecting portion between the rib and the movable plate (in other words, the base of the rib), which is technically problematic. In other words, there is such a technical problem that stress may concentrate in the connecting portion between the rib and the movable plate. As a result, such an increase in stress may cause the rib and the movable plate to be destroyed or damaged (or cause the rib to be separated or peeled from the movable plate), which is technically problematic.

On the other hand, the stress that is also applied to the movable plate when the twisting stress is applied to the torsion bar tends to be higher as an area portion to which the stress is applied becomes closer to the torsion bar. Thus, if the rib is formed in an area portion that is as far from the torsion bar as possible (i.e. if the rib is formed near the center of the movable part) as one of the measures to avoid the concentration of the stress in the connecting portion between the rib and the movable plate, it is possibly hard to suppress the deformation of the movable plate.

Thus, from the viewpoint of suppressing the deformation of the movable plate while avoiding the concentration of the stress in the connecting portion between the rib and the movable plate, there can be considered a measure to form the rib that extends in a direction of a rotation axis of the movable plate while avoiding a connecting portion between the torsion bar and the movable plate on which the stress tends to concentrate. However, even if such a measure is adopted, it is hard to avoid the concentration of the stress in the connecting portion between the rib and the movable plate, near an end portion of the rib.

In view of the aforementioned problems, it is therefore an object of the present invention to provide an actuator that can relieve or reduce the stress that is applied to the connecting portion between the rib and the movable plate.

### Solution to Problem

The present invention provides an actuator according to claim 1. Further embodiments of the present invention are described in the dependent claims.

The operation and other advantages of the present invention will become more apparent from an embodiment and an example explained below.

### Brief Description of Drawings

[FIG. 1] FIG. 1 is a plan view illustrating one example of a configuration of an actuator according to an example, observed from an upper surface side.
[FIG. 2] FIG. 2 is a plan view illustrating one example of the configuration of the actuator according to the example, observed from a lower surface side.
[FIG. 3] FIG. 3 is a conceptual diagram illustrating one example of a stress distribution of stress applied to a movable part when a rib is not formed.
[FIG. 4] FIG. 4 is an enlarged plan view and an enlarged side view enlarging and illustrating the vicinity of the movable part according to the example.
[FIG. 5] FIG. 5 is an enlarged view enlarging and illustrating a part of the rib according to the example.
[FIG. 6] FIG. 6 is a conceptual diagram illustrating one example of a shape of the rib and stress applied to the rib.
[FIG. 7] FIG. 7 is a diagram illustrating one example of a simulation result of the stress applied to the movable part in which the rib illustrated in FIG. 6 is formed.
[FIG. 8] FIG. 8 is a conceptual diagram illustrating another example of the shape of the rib and the stress applied to the rib.
[FIG. 9] FIG. 9 is a diagram illustrating one example of a simulation result of the stress applied to the movable part in which the rib illustrated in FIG. 8 is formed.

### Description of Embodiment

Hereinafter, an actuator according to an embodiment of the present invention will be explained.

The actuator according to the embodiment is provided with: a planar movable part; a support part for supporting the movable part; and a torsion bar for connecting the movable part and the support part in a longitudinal direction so that the movable part can oscillate around a rotation axis in the longitudinal direction. A reflection part is formed on one surface of the movable part, and one or a plurality of ribs for maintaining flatness of the movable part are formed on another surface opposite to the one surface of the movable part. A first rib included in the one or the plurality of ribs extends in a lateral direction, which crosses the longitudinal direction (i.e. the longitudinal direction of the torsion bar), on the other surface.

A side surface of the first rib on a side of the torsion bar is concave in a portion that is away from the rotation axis, in a plane view on the other surface. A degree of a concave of the side surface in the portion that is away from the rotation axis is greater than a degree of a concave of the side surface in the vicinity of the rotation axis. In other words, the curvature of the first rib in the portion that is away from the rotation axis is greater than the curvature of the first rib in the vicinity of the rotation axis.

In the actuator, the movable part suspended by the torsion bar oscillates. The movable part may be oscillated to rotate, for example, around an axis in an extending direction of the torsion bar (i.e. in the longitudinal direction of the torsion bar) as the rotation axis.

In order to realize the rotation of the movable part as described above, the torsion bar connects the movable part and the support part in the longitudinal direction of the torsion bar. At this time, the torsion bar may directly connect the movable part and the support part. Alternatively, the torsion bar may connect the movable part and the support part, indirectly (in other words, via an arbitrary member between the two parts).

On the one surface of the movable part, the reflection part, such as, for example, a mirror that can reflect laser light, is formed. On the other surface of the movable part, the one or the plurality of ribs are formed. The rib(s) is formed mainly to maintain the flatness or planarity of the movable part (in other words, to suppress the deformation of the movable part, or to maintain the rigidity or stiffness of the movable part). In order to realize such a purpose, the rib desirably has a convex shape with respect to the other surface of the movable part (in other words, has a shape projecting toward a normal direction of the movable part).

Particularly in the embodiment, the first rib extends in the lateral direction on the other surface of the movable part. Then, the side surface of the first rib on the torsion bar side is concave in the portion that is away from the rotation axis, in a plane view on the other surface. The degree of the concave of the side surface in the portion that is away from the rotation axis is greater than the degree of the concave of the side surface in the vicinity of the rotation axis.

The provision of the first rib can suppress deflection of the reflection part, when driving the actuator.

With increasing the curvature of the first rib, stress is more hardly applied to a connecting portion between the first rib and the movable part. As described above, stress applied to the vicinity of an end of the first rib can be reduced by relatively increasing the curvature of the portion of the first rib that is away from the rotation axis. As a result, it is possible to preferably suppress that the first rib is destroyed or damaged due to stress applied to the movable part or the like, in operation of the actuator.

In one aspect of the actuator according to the embodiment, the first rib is formed in an area on the other surface of the movable part corresponding to an area between an outer edge of the reflection part and the torsion bar. The first rib is curved to be convex on a side of the reflection part, in a plane view on the other surface.

By virtue of such a configuration, even if the torsion bar is relatively significantly deflected, the deflection of a reflection surface can be significantly suppressed due to the first rib. In addition, since the first rib is curved to be convex on the reflection part side, in a plane view on the other surface of the movable part, it is possible to suppress the stress applied to the connecting portion between the first rib and the movable part, and to suppress that the first rib is destroyed or damaged.

In another aspect of the actuator according to the embodiment, the side surface of the first rib on the torsion bar side is convex toward the side of the torsion bar in the vicinity of the rotation axis, in a plane view on the other surface of the movable part.

According to the studies of the present inventors, it has been found that stress is easily applied to a portion that is a little away from the rotation axis of the movable part in a rotation radius direction, in a plane view on the movable part. It is thus possible to relatively increase the curvature of a portion of the first rib in which stress is easily applied, by setting the side surface of the first rib on the torsion bar side in the vicinity of the rotation axis to be convex toward the torsion bar side. As a result, stress applied to the first rib can be reduced, which is extremely useful in practice.

In another aspect of the actuator according to the embodiment, the movable part has a projection portion projecting toward an outside of the movable part, along the other surface of the movable part, in comparison with a peripheral portion, in the vicinity of a connecting portion between the torsion bar and the movable part, and a part of the first rib is formed on the other surface so as to extend on the projection portion.

By virtue of such a configuration, since the part of the first rib extends on the projection portion, it is possible to relieve or reduce the stress applied to the connecting portion between the first rib and the movable part, in association with the oscillation of the movable part. In other words, it is possible to relieve or reduce concentration of the stress in the connecting portion between the first rib and the movable part associated with the oscillation of the movable part.

In another aspect of the actuator according to the embodiment, a second rib included in the one or the plurality of ribs is formed in an area on the other surface of the movable part corresponding to an area on the one surface in which the reflection part is formed.

By virtue of such a configuration, the deformation of the movable part can be suppressed, which is extremely useful in practice. The first rib and the second rib may be connected to each other.

### Example

An actuator according to an example of the present invention will be explained with reference to the drawings.

### (Entire Configuration of Actuator)

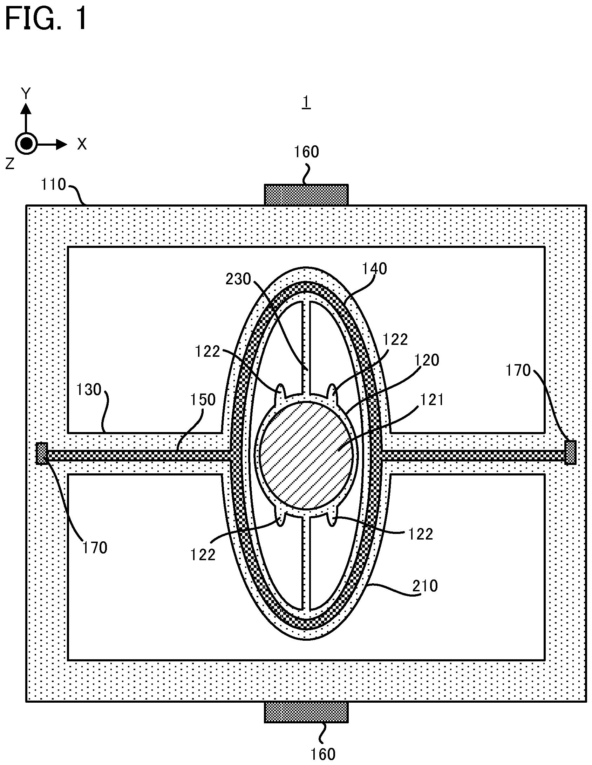

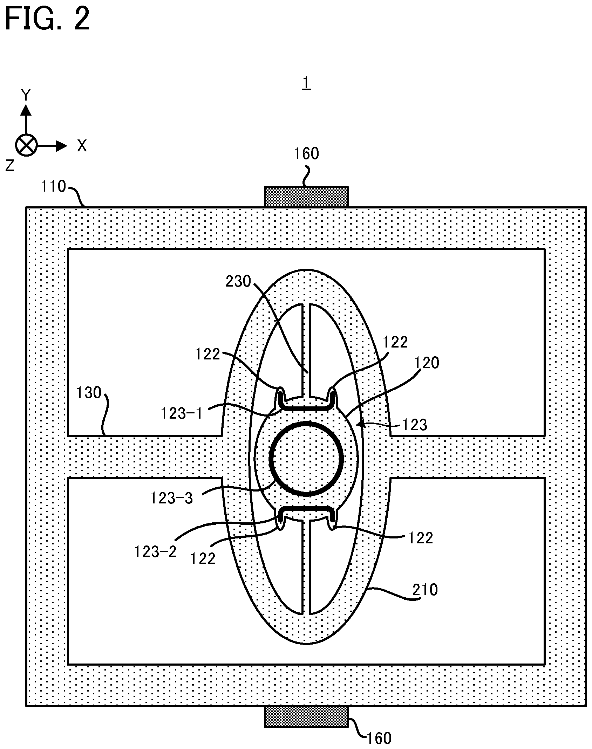

An entire configuration of the actuator according to the example will be explained with reference to FIG. 1 and FIG. 2. FIG. 1 is a plan view illustrating one example of the configuration of the actuator according to the example, observed from an upper surface side. FIG. 2 is a plan view illustrating one example of the configuration of the actuator according to the example, observed from a lower surface side. In FIG. 1 and FIG. 2, a virtual three-dimensional space defined by an X axis, a Y axis, and a Z axis is used to explain the actuator according to the example.

In FIG. 1 and FIG. 2, an actuator 1 is, for example, a planar type electromagnetic drive actuator (i.e. MEMS scanner) used for laser light scanning. The actuator 1 is provided with an outer support 110, a pair of torsion bars 130, an inner support 210, a pair of torsion bars 230, a movable part 120, a drive coil 140, a pair of permanent magnets 160, and a pair of power supply terminals 170.

Moreover, as illustrated in FIG. 1, a mirror 121 is formed on an upper surface or a surface on the front side (corresponding to the "one surface" according to the present invention) of the movable part 120. As illustrated in FIG. 2, a rib 123 is formed on a lower surface or a surface on the rear side (corresponding to the "other surface" according to the present invention) of the movable part 120.

The outer support 110, the pair of torsion bars 130, the inner support 210, the pair of torsion bars 230, the movable part 120, and the rib 123 are integrally formed from a nonmagnetic substrate, such as, for example, a silicon substrate. In other words, the outer support 110, the pair of torsion bars 130, the inner support 210, the pair of torsion bars 230, and the movable part 120 are formed by removing a part of the nonmagnetic substrate, such as, for example, the silicon substrate, to form a gap. A formation process at this time desirably uses a MEMS process.

The outer support 110, the pair of torsion bars 130, the inner support 210, the pair of torsion bars 230, the movable part 120, and the rib 123 may be integrally formed from an arbitrary elastic material, instead of the silicon substrate.

The outer support 110 has a frame shape so as to surround the inner support 210. The outer support 110 is connected to the inner support 210 by the pair of torsion bars 130, which are located on both sides of the inner support 210 (in other words, which sandwiches the inner support 210 from the both sides of the inner support 210).

The example exemplifies that the shape of the outer support 110 is the frame shape; however, the shape of the outer support 110 is obviously not limited to the frame shape. The shape of the outer support 110 may be, for example, a frame shape that is partially open.

The inner support 210 has a frame shape so as to surround the movable part 120. The inner support 210 is pivotably supported on the outer support 110 by the pair of torsion bars 130 so that the inner support 210 can oscillate around a rotation axis in an extending direction of the pair of torsion bars 130 (i.e. in a longitudinal direction of the pair of torsion bars 130, and in a direction of the X axis in FIG. 1 and FIG. 2).

The inner support 210 is further connected to the movable part 120 by the pair of torsion bars 130, which are located on both sides of the movable part 120 (in other words, which sandwich the movable part 120 from the both sides of the movable part 120).

On an upper surface of the inner support 210, as illustrated in FIG. 1, the drive coil 140 is formed. The drive coil 140 may be formed inside or on a lower surface of the inner support 210.

The example exemplifies that the shape of the inner support 210 is the frame shape; however, the shape of the inner support 210 is obviously not limited to the frame shape. The shape of the inner support 210 may be, for example, a frame shape that is partially open.

The movable part 120 is pivotably supported on the inner support 210 by the pair of torsion bars 230 so that the movable part 120 can oscillate around a rotation axis in an extending direction of the pair of torsion bars 230 (i.e. in a longitudinal direction of the pair of torsion bars 230, and in a direction of the Y axis in FIG. 1 and FIG. 2).

The movable part 120 has one or a plurality of projection portions (in FIG. 1 and FIG. 2, four projection portions) 122. The projection portion 122 is an area portion projecting in comparison with an area portion around the projection portion 122 (in other words, an area portion adjacent to the projection portion 122). More specifically, the projection portion 122 projects in a direction along the surface of the movable part 120 (in other words, in a direction along an X-Y plane) and toward the outside of the movable part 120.

The projection portion 122 is desirably integrated with the movable part 120 (in other words, is integrally formed from the same structure). The projection portion 122 may have a structure added (in other words, connected or attached) to the movable part 120 later. Moreover, the projection portion 122 is preferably located on the same plane with the movable part 120. The thickness of the projection portion 122 is preferably the same as the thickness of the movable part 120.

In the example illustrated in FIG. 1 and FIG. 2, the projection portion 122 projects in a direction along the rotation axis of the movable part 120 (i.e. the Y axis). This is to suppress an increment in inertia moment of the movable part 120 around the rotation axis.

Moreover, fillet processing (or chamfering, bending, rounding, etc.) for rounding corners is preferably performed on a boundary between each projection portion 122 and the area portion around the projection portion 122.

On the upper surface of the movable part 120, as described above, the mirror 121 configured to reflect laser light is formed. Here, the movable part 120 is desirably, for example, a plate-like (in other words, a planar) member.

Moreover, in order that the mirror 121 preferably reflects the laser light, the flatness of the mirror 121 is preferably maintained. In order to maintain the flatness of the mirror 121, the flatness of the movable part 120 needs to be maintained. Thus, in the example, in order to maintain the flatness of the movable part 120, the rib 123 is formed on the lower surface of the movable part 120 (i.e. on a surface on an opposite side of the surface with the mirror 121 formed thereon)

The rib 123 is formed on the lower surface of the movable part 120 in a desired aspect that allows the flatness of the movable part 120 to be ensured. In the example, the rib 123 includes: a first rib portion 123-1 and a second rib portion 123-2, which extend in the X axis direction in the vicinity of connecting portions between the movable part 120 and the torsion bars 230; and a third rib portion 123-3 having a shape corresponding to the shape (or circular shape herein) of the mirror 121.

The aspect of the rib 123 as described above is determined from the viewpoint of ensuring the rigidity or stiffness of the movable part 120 in the direction along the X axis and in the direction along the Y axis as much as possible. The aspect of the rib 123 illustrated in FIG. 2 is obviously one example.

The pair of torsion bars 130 connects the inner support 210 and the outer support 110 so that the inner support 210 can oscillate with respect to the outer support 110. Due to the elasticity of the pair of torsion bars 130, the inner support 210 oscillates so as to rotate around an axis in the extending direction of the pair of torsion bars 130 as the rotation axis. In other words, the inner support 210 oscillates so as to rotate around the X axis in FIG. 1 and FIG. 2 as the rotation axis.

Here, the movable part 120 is connected to the inner support 210 via the pair of torsion bars 230. Therefore, with the oscillation of the inner support 210, the movable part 120 practically oscillates so as to rotate around the X axis in FIG. 1 and FIG. 2 as the rotation axis.

Each of the pair of torsion bars 230 connects the movable part 120 and the inner support 210 so that the movable part 120 can oscillate with respect to the inner support 210. Due to the elasticity of the pair of torsion bars 230, the movable part 120 oscillates so as to rotate around an axis in the extending direction of the pair of torsion bars 230 as the rotation axis. In other words, the movable part 120 oscillates so as to rotate around the Y axis in FIG. 1 and FIG. 2 as the rotation axis.

The drive coil 140 is, for example, a coil extending on the inner support 210. The drive coil 140 may be formed by using, for example, a material with relatively high conductivity (e.g. gold, copper, etc.). The drive coil 140 may be also formed by using a semiconductor manufacturing process, such as a plating process and a sputtering method. Alternatively, the drive coil 140 may be embedded by an implant method, with respect to a silicon substrate for forming the outer support 110, the pair of torsion bars 130, the inner support 210, the pair of torsion bars 230, the movable part 120, and the rib 123.

In FIG. 1, to make it easy to look at the drawing, the outer shape of the drive coil is simplified and drawn; however, the drive coil 140 is practically configured by one or a plurality of windings formed on the surface of the inner support 210.

The drive coil 140 is supplied with a control current from a power supply via the pair of power supply terminals 170, which are formed on the outer support 110, and via wires 150, which are to electrically connect the pair of power supply terminals 170 and the drive coil 140 and which are formed on the pair of torsion bars 130.

The control current is a control current for oscillating the inner support 210 and the movable part 120, and is typically an alternating current containing a signal component of frequency synchronized with oscillation frequency of the inner support 210 and a signal component of frequency synchronized with oscillation frequency of the movable part 120. The power supply may be a power supply provided for the actuator 1, or may be a power supply prepared outside the actuator 1.

The pair of permanent magnets 160 is mounted outside the outer support 110. The pair of permanent magnets 160, however, may be mounted anywhere as long as a predetermined static magnetic field can be applied to the drive coil 140.

The pair of permanent magnets 160 is preferably set to have appropriate direction of magnetic poles thereof so that the predetermined static magnetic field can be applied to the drive coil 140. The pair of permanent magnets 160 may have yokes added to increase the strength of the static magnetic field.

### (Operation of Actuator)

If the actuator 1 as configured above operates (specifically, the movable part 120 oscillates), firstly, the control current is supplied to the drive coil 140 via the power supply terminals 170 and the wires 150 from the power supply. The control current supplied to the drive coil 140 at this time is preferably a current obtained by superimposing a signal for oscillating the inner support 210 (specifically a signal synchronized with an oscillation period of the inner support 210) and a signal for oscillating the movable part 120 (specifically, a signal synchronized with an oscillation period of the movable part 120).

On the other hand, the static magnetic field is applied to the drive coil 140 by the pair of permanent magnets 160. Therefore, force caused by electromagnetic interaction between the static magnetic field applied from the pair of permanent magnets 160 and the control current supplied to the drive coil 140 (i.e. the Lorentz force) is generated on the drive coil 140.

As a result, the inner support 210 with the drive coil 140 formed thereon oscillates due to the Lorentz force caused by the electromagnetic interaction between the static magnetic field applied from the pair of permanent magnets 160 and the control current supplied to the drive coil 140. In other words, the inner support 210 oscillates so as to rotate around the X axis in FIG. 1 as the rotation axis. Here, the movable part 120 is connected to the inner support 210 via the pair of torsion bars 230. Therefore, with the oscillation of the inner support 210, the movable part 120 practically oscillates so as to rotate around the X axis in FIG. 1 as the rotation axis.

In addition, the Lorentz force caused by the electromagnetic interaction between the static magnetic field applied from the pair of permanent magnets 160 and the control current supplied to the drive coil 140 is transmitted to the movable part 120 as inertia force. As a result, the movable part 120 oscillates so as to rotate around the Y axis in FIG. 1 as the rotation axis.

As described above, according to the actuator 1 in the example, biaxial drive of the movable part 120 is performed.

In the example, the biaxial drive of the movable part 120 is performed by using the Lorentz force itself to oscillate the inner support 210 and by using the Lorentz as the inertia force to oscillate the movable part 120. However, the drive coil for generating the Lorentz force for oscillating the movable part 120 may be formed on the movable part 120. In this case, wires connecting from the power supply terminals 170 on the outer support 110 to the drive coil on the movable part 120 are preferably formed on the pair of torsion bars 230 (or further, on the inner support 210, the pair of torsion bars 130, and the outer support 110).

### (Detailed Explanation of Rib)

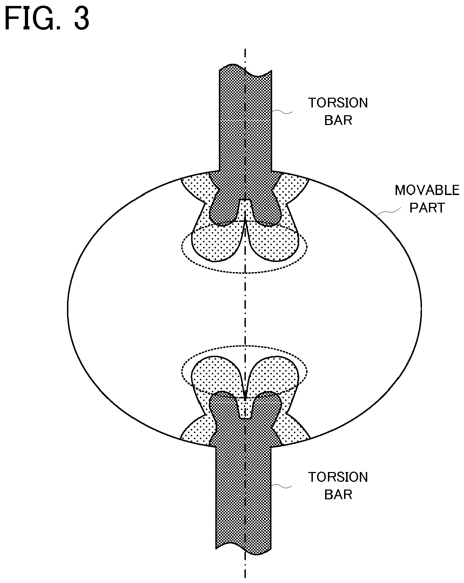

The rib 123 according to the example will be explained with reference to FIG. 3 to FIG. 5.

Firstly, stress applied to the movable part 120 will be explained with reference to FIG. 3. FIG. 3 is a conceptual diagram illustrating one example of a stress distribution of the stress applied to the movable part when the rib is not formed. In FIG. 3, darker color indicates higher stress.

When the actuator operates as described above and the movable part is biaxially driven, if the rib is not formed on the movable part, then, the stress distribution of the movable part is, for example, as illustrated in FIG. 3; namely, stress is applied to an area that is a little away from the rotation axis of the movable part (or an alternate long and short dash line in FIG. 3).

In order to maintain the flatness of the mirror (refer to FIG. 1) formed on the movable part, firstly, it is necessary to reduce the stress in portions illustrated by dotted circles in FIG. 3. In addition, as illustrated in FIG. 3, relatively high stress is applied to the vicinity of the connecting portions between the movable part and the torsion bars. It is thus necessary to reduce the stress applied to a connecting portion between the movable part and the rib, which is formed on the movable part.

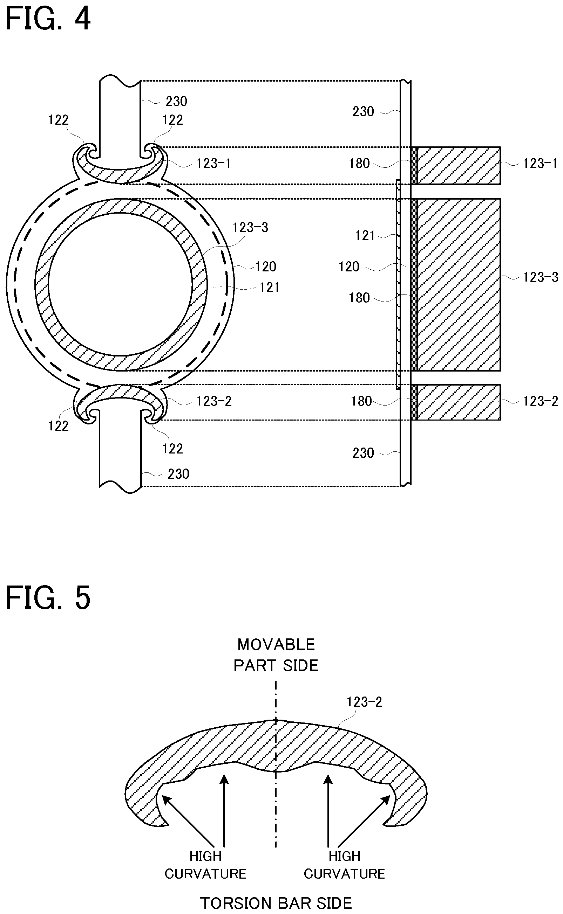

Therefore, in the example, as illustrated in FIG. 4, the first rib portion 123-1 and the second rib portion 123-2 are formed in areas corresponding to areas between an outer edge of the mirror 121 (refer to a dashed line in FIG. 4) and the torsion bars 230, on the lower surface of the movable part 120 (i.e. on the surface of the movable part 120 on the side illustrated in FIG. 2). The first rib portion 123-1 and the second rib portion 123-2 are curved to be convex on the mirror 121 side, in a plane view on the movable part 120.

The provision of the first rib portion 123-1 and the second rib portion 123-2 as described above can significantly suppress the stress applied to the mirror 121 (or the stress applied to the portions illustrated by the dotted circles in FIG. 3).

By the way, the actuator 1 (i.e. the MEMS scanner) is manufactured from a silicon on insulator (SOI) wafer in many cases. Moreover, the rib 123 is made of, for example, silicon in many cases. On the other hand, a box layer (in other words, an oxide film layer) 180 exists between the movable part 120 or each of the torsion bars 230 (in other words, a device layer or an active layer) and the rib 123 (in other words, a handle layer or a support layer) (refer to the right side in FIG. 4).

The box layer 180 is weaker than the movable part 120 and the rib 123, and is thus easily destroyed or damaged by the stress associated with the oscillation of the movable part 120. The destruction or damage of the box layers 180 may cause the rib 123 to be separated or peeled from the movable part 120.

Moreover, in FIG. 3, in the connecting portions between the torsion bars and the movable part, a distance in a width direction (in other words, a direction crossing a direction from the torsion bars to the movable part: a horizontal direction in FIG. 3) suddenly becomes long. Therefore, the stress associated with the oscillation of the movable part concentrates on the connecting portions between the torsion bars and the movable par.

Thus, in the example, as described above, the movable part 120 is provided with the projection portions 122, and a part of each of the first rib portion 123-1 and the second rib portion 123-2 is formed to extend on respective one of the projection portions 122. The stress associated with the oscillation of the movable part 122 is hardly applied to the projection portions 122.

Therefore, the stress associated with the oscillation of the movable part 122 does not concentrate on the part of each of the first rib portion 123-1 and the second rib portion 123-2 formed on respective one of the projection portions 122 (in other words, the base of each of the first rib portion 123-1 and the second rib portion 123-2). In other words, the stress associated with the oscillation of the movable part 122, which is applied to the base of each of the first rib portion 123-1 and the second rib portion 123-2, is relieved or reduced.

As a result, the stress associated with the oscillation of the movable part 122, which is applied to each of the box layers 180, is also relieved or reduced, and the separation or peeling of the rib 123 from the movable part 120 can be suppressed, by which a practically advantageous effect is obtained.

According to the studies of the present inventors, the following matter has been found; namely, the stress easily concentrate if the rib is convex in a direction opposite to a direction in which the stress is applied to the rib (here, a direction directed from the torsion bar(s) 230 to the movable part 120). On the other hand, the stress is hardly applied to the rib if the rib is convex in the direction in which the stress is applied to the rib (in other words, if the rib is concave in the direction opposite to the direction in which the stress is applied to the rib). Then, an area partially surrounded by the rib is more hardly deformed by the stress with increasing the curvature of the rib.

Thus, in the example, as illustrated in FIG. 5, the curvature of a portion of the second rib portion 123-2 on which the stress relatively concentrates is set to be relatively high (the same applies to the first rib portion 123-1). Particularly here, in a portion having relatively low stress, the wall surface of the second rib portion 123-2 on the torsion bar 230 side is set to be convex toward the torsion bar 230 side. As a result, it is possible to form the second rib portion 123-2 in a predetermined position in the connecting portion between the movable part 120 and the torsion bar 230 while increasing the curvature of the portion on which the stress relatively concentrates as much as possible.

### (Verification of Effect of the Invention)

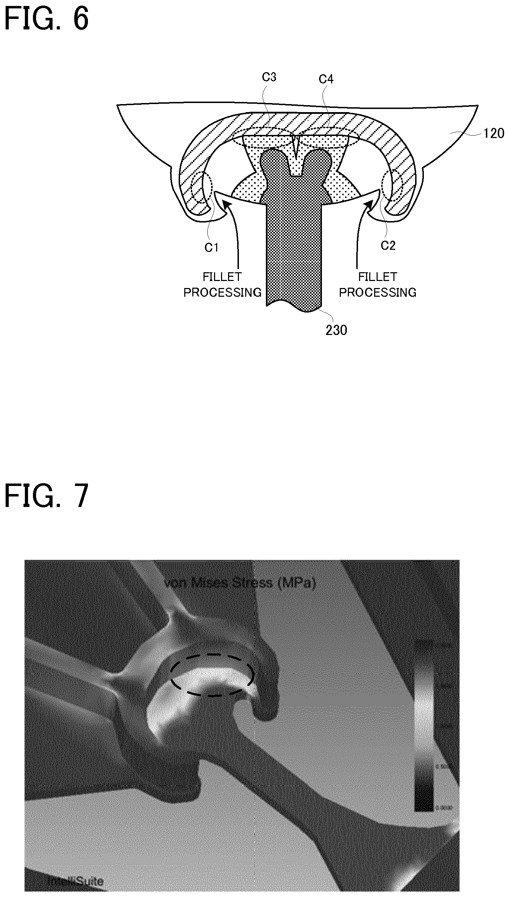

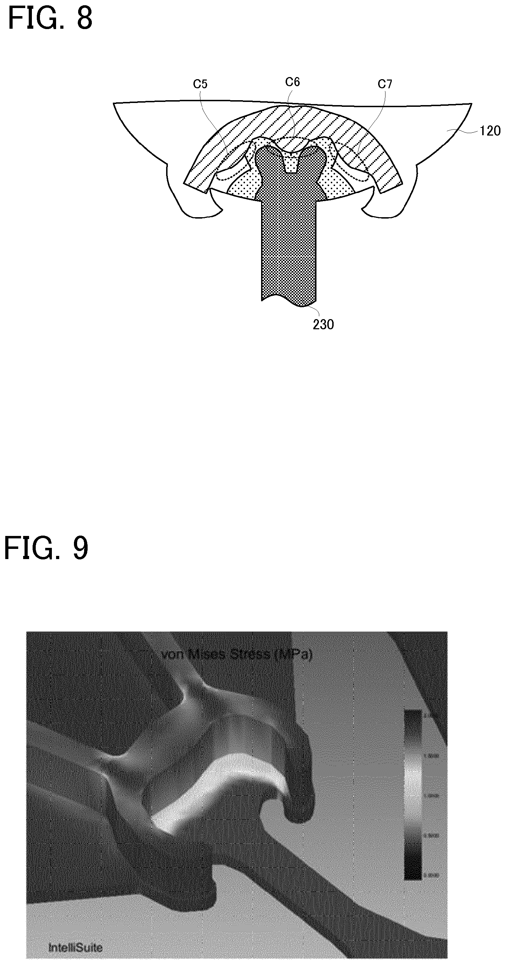

Next, an effect of the present invention will be explained with reference to FIG. 6 to FIG. 9. FIG. 6 is a conceptual diagram illustrating one example of the shape of the rib and the stress applied to the rib. FIG. 7 is a diagram illustrating one example of a simulation result of the stress applied to the movable part in which the rib illustrated in FIG. 6 is formed. FIG. 8 is a conceptual diagram illustrating another example of the shape of the rib and the stress applied to the rib. FIG. 9 is a diagram illustrating one example of a simulation result of the stress applied to the movable part in which the rib illustrated in FIG. 8 is formed.

As illustrated in FIG. 6, it is clear that the stress applied to a part of the rib is reduced by forming the part of the rib (or an oblique line portion in FIG. 6) so as to extend on the projection portions 122. Particularly here, in order that the stress concentrates on the portions of the movable part 120 in which the fillet processing is performed, the curvature of portions of the rib surrounded by dotted circles C1 and C2 in FIG. 6 is desirably as high as possible.

On the other hand, in a portion of the rib that extends in a width direction of the torsion bar 230 (i.e. in a horizontal direction in FIG. 6), the stress is relatively applied to portions surrounded by dotted circles C3 and C4. In this regard, the same result is obtained even by simulations (refer to a dashed circle in FIG. 7).

Thus, in order to reduce the stress applied to the portions of the rib surrounded by the dotted circles C3 and C4 in FIG. 4, as illustrated in FIG. 8, a portion(s) having relatively low stress applied out of the side surface of the rib on the torsion bar 230 side is set to be convex toward the torsion bar 230 side (refer to dotted circles C5, C6, and C7).

As a result, the curvature of the portions of the rib surrounded by the dotted circles C3 and C4 in FIG. 6 is relatively high, and the stress to the portions can be thus reduced. In this regard, the same result is obtained even by simulations (refer to FIG. 9).

Particularly here, in the simulation result illustrated in FIG. 9, it is clear that the stress applied to the side surface of the rib on the torsion bar 230 side is substantially uniform. It is therefore possible to preferably suppress that the rib 123 is separated or peeled from the movable part 120 due to the stress associated with the oscillation of the movable part 120.

The "first rib portion 123-1" and the "second rib portion 123-2" according to the example are one example of the "first rib" according to the present invention. The "inner support 210", the "torsion bar 230", the "mirror 121", and the "third rib portion 123-3" according to the example are respectively one example of the "support part", the "torsion bar", the "reflection part", and the "second rib" according to the present invention.

The present invention is not limited to the aforementioned embodiments and examples, but various changes may be made, if desired, without departing from the scope of the claims. An actuator that involves such changes is also intended to be within the technical scope of the present invention as defined in the claims.

### Description of Reference Numerals and Letters

- 1: actuator,
- 110: outer support
- 120: movable part
- 121: mirror
- 122: projection portion
- 123: rib
- 130, 230: torsion bar
- 140: drive coil
- 150: wire
- 160: permanent magnet
- 210: inner support

## Claims

1. An actuator (1) comprising:
a planar movable part (120);
a support part (210) for supporting the movable part (120); and
a torsion bar (230) for connecting the movable part (120) and the support part (210) in a longitudinal direction so that the movable part (120) can oscillate around a rotation axis in the longitudinal direction, wherein
a reflection part (121) is formed on one surface of the movable part (120),
one or a plurality of ribs (123) for maintaining flatness of the movable part (120) are formed on an other surface opposite to the one surface of the movable part (120),
a first rib (123-1, 123-2) included in the one or the plurality of ribs (123) extends in a lateral direction, which crosses the longitudinal direction, on the other surface,
a side surface of the first rib (123-1, 123-2) on a side of the torsion bar (230) is concave in a portion that is away from the rotation axis, in a plane view on the other surface,
a degree of a concave of the side surface in the portion that is away from the rotation axis is greater than a degree of a concave of the side surface in the vicinity of the rotation axis,
the first rib (123-1, 123-2) is formed in an area on the other surface corresponding to an area between an outer edge of the reflection part (121) and the torsion bar (230), and
the first rib (123-1, 123-2) is curved to be convex on a side of the reflection part (121), in a plane view on the other surface.

2. The actuator (1) according to claim 1, wherein
the side surface of the first rib (123-1, 123-2) is convex toward the side of the torsion bar (230) in the vicinity of the rotation axis, in a plane view on the other surface.

3. The actuator (1) according to claim 1, wherein
the movable part (120) has a projection portion (122) projecting toward an outside of the movable part (120), along the other surface, in comparison with a peripheral portion, in the vicinity of a connecting portion between the torsion bar (230) and the movable part (120), and
a part of the first rib (123-1, 123-2) is formed on the other surface so as to extend on the projection portion (122).

4. The actuator (1) according to claim 1, wherein a second rib (123-3) included in the one or the plurality of ribs (123) is formed in an area on the other surface corresponding to an area on the one surface in which the reflection part (121) is formed.

## Patentansprüche

1. Ein Aktor (1) aufweisend:
einen ebenflächigen bewegbaren Abschnitt (120);
einen Halteabschnitt (210) zum Halten des bewegbaren Abschnitts (120) und
einen Drehstab (230) zum Verbinden des bewegbaren Abschnitts (120) mit dem Halteabschnitt (210) in einer Längsrichtung, sodass der bewegbare Abschnitt (120) um eine Rotationsachse in der Längsrichtung oszillieren kann, wobei
ein Reflexionsabschnitt (121) auf einer Fläche des bewegbaren Abschnitts (120) gebildet ist,
eine oder eine Mehrzahl von Rippen (123) zum Beibehalten der Flachheit des bewegbaren Abschnitts (120) auf einer anderen Fläche gegenüber der einen Fläche des bewegbaren Abschnitts (120) gebildet ist,
eine erste Rippe (123-1, 123-2), welche von der einen oder der Mehrzahl von Rippen (123) aufgewiesen wird, sich in einer die Längsrichtung kreuzenden Seitenrichtung auf der anderen Fläche erstreckt,
eine Seitenfläche der ersten Rippe (123-1, 123-2) auf einer Seite des Drehstabs (230), in einer Draufsicht auf die andere Fläche, in einem von der Rotationsachse entfernten Abschnitt konkav ist,
ein Konkavitätsgrad der Seitenfläche in dem von der Rotationsachse entfernten Abschnitt größer ist als ein Konkavitätsgrad der Seitenfläche in der Nähe der Rotationsachse,
die erste Rippe (123-1, 123-2) in einem Bereich auf der anderen Fläche gebildet ist, der mit einem Bereich zwischen einem Außenrand des Reflexionsabschnitts (121) und dem Drehstab (230) korrespondiert, und
die erste Rippe (123-1, 123-2) gekrümmt ist, um, in einer Draufsicht auf die andere Fläche, auf einer Seite des Reflexionsabschnitts (121) konvex zu sein.

2. Der Aktor (1) gemäß Anspruch 1, wobei
die Seitenfläche der ersten Rippe (123-1, 123-2), in einer Draufsicht auf die andere Fläche, in der Nähe der Rotationsachse zu der Seite des Drehstabs (230) hin konvex ist.

3. Der Aktor (1) gemäß Anspruch 1, wobei
der bewegbare Abschnitt (120) einen Vorsprungsabschnitt (122) hat, welcher zu einer Außenseite des bewegbaren Abschnitts (120) hin vorsteht, entlang der anderen Fläche, im Vergleich zu einem Umfangsabschnitt, in der Nähe eines Verbindungsabschnitts zwischen dem Drehstab (230) und dem bewegbaren Abschnitt (120), und
ein Abschnitt der ersten Rippe (123-1, 123-2) an der anderen Fläche gebildet ist, sodass er sich auf dem Vorsprungsabschnitt (122) erstreckt.

4. Der Aktor (1) gemäß Anspruch 1, wobei eine zweite Rippe (123-3), welche von der einen oder der Mehrzahl von Rippen (123) aufgewiesen wird, in einem Bereich auf der anderen Fläche gebildet ist, der mit einem Bereich auf der einen Fläche korrespondiert, in welchem der Reflexionsabschnitt (121) gebildet ist.

## Revendications

1. Actionneur (1) comprenant :
une partie mobile planaire (120) ;
une partie de support (210) pour supporter la partie mobile (120) ; et
une barre de torsion (230) pour raccorder la partie mobile (120) et la partie de support (210) dans une direction longitudinale de sorte que la partie mobile (120) peut osciller autour d'un axe de rotation dans la direction longitudinale, dans lequel :
une partie de réflexion (121) est formée sur une surface de la partie mobile (120),
une ou une pluralité de nervures (123) pour maintenir la planéité de la partie mobile (120), sont formées sur une autre surface opposée à la première surface la partie mobile (120),
la première nervure (123-1, 123-2) comprise dans l'une ou la pluralité de nervures (123), s'étend dans une direction latérale, qui coupe la direction longitudinale, sur l'autre surface,
une surface latérale de la première nervure (123-1, 123-2) sur un côté de la barre de torsion (230) est concave dans une partie qui est éloignée de l'axe de rotation, sur une vue en plan de l'autre surface,
un degré de concavité de la surface latérale dans la partie qui est éloignée de l'axe de rotation est supérieur à un degré de concavité de la surface latérale à proximité de l'axe de rotation,
la première nervure (123-1, 123-2) est formée dans une zone sur l'autre surface correspondant à une zone entre un bord externe de la partie de réflexion (121) et la barre de torsion (230), et
la première nervure (123-1, 123-2) est incurvée pour être convexe sur un côté de la partie de réflexion (121), sur une vue en plan sur l'autre surface.

2. Actionneur (1) selon la revendication 1, dans lequel :
la surface latérale de la première nervure (123-1, 123-2) est convexe vers le côté de la partie de torsion (230) à proximité de l'axe de rotation, sur une vue en plan, sur l'autre surface.

3. Actionneur (1) selon la revendication 1, dans lequel :
la partie mobile (120) a une partie de saillie (122) faisant saillie vers un extérieur de la partie mobile (120), le long de l'autre surface, par rapport à une partie périphérique, à proximité d'une partie de raccordement entre la barre de torsion (230) et la partie mobile (120), et
une partie de la première nervure (123-1, 123-2) est formée sur l'autre surface afin de s'étendre sur la partie de saillie (122).

4. Actionneur (1) selon la revendication 1, dans lequel une seconde nervure (123-3) comprise dans l'une ou la pluralité de nervures (123), est formée dans une zone sur l'autre surface correspondant à une zone sur la première surface dans laquelle la partie de réflexion (121) est formée.
